## Europäisches Patentamt

## European Patent Office

(11) Publication number: **0 178 336**

## Office européen des brevets

**B1**

(12) EUROPEAN PATENT SPECIFICATION

(45) Date of publication of patent specification: **09.09.87**

(51) Int. Cl.⁴: **H 01 L 21/68**

(21) Application number: **84112378.9**

(22) Date of filing: **16.10.84**

(54) Vacuum transfer device.

(43) Date of publication of application:
**23.04.86 Bulletin 86/17**

(45) Publication of the grant of the patent:
**09.09.87 Bulletin 87/37**

(84) Designated Contracting States:
**DE FR GB**

(56) References cited:
**FR-A-2 403 866**

**IBM TECHNICAL DISCLOSURE BULLETIN, vol.
17, no. 8, January 1975, pages 2268-2269, New
York, US; Y. BUDO et al.: "Modular vacuum
system"**

**IBM TECHNICAL DISCLOSURE BULLETIN, vol.
18, no. 2, July 1975, pages 341-342, New York,
US; J.C. KENISH et al.: "Stepping motor
actuated chip handler"**

(73) Proprietor: **International Business Machines
Corporation
Old Orchard Road
Armonk, N.Y. 10504 (US)**

(72) Inventor: **Bednorz, Johannes Georg, Dr.
Sonnenbergstrasse 47
CH-8134 Adliswil (CH)**
Inventor: **Gueret, Pierre Leopold, Dr.
Im Gruet 2,
CH-8805 Richterswil (CH)**
Inventor: **Nievergelt, Hermann Emil
Rellstenstrasse 9
CH-8134 Adliswil (CH)**
Inventor: **Ott, Hanspeter
Alte Landstrasse 22
CH-8800 Thalwil (CH)**
Inventor: **Pohl, Wolfgang Dieter, Dr.
Felsenhofstrasse 10
CH-8134 Adliswil (CH)**
Inventor: **Widmer, Daniel Felix
Vorderi Siten 11
CH-8816 Hirzel (CH)**

(74) Representative: **Rudack, Günter O., Dipl.-Ing.
IBM Corporation Säumerstrasse 4
CH-8803 Rüschlikon (CH)**

Courier Press, Leamington Spa, England.

## Description

This invention relates to a vacuum transfer device for use in connection with the manufacture or measuring investigation of electronic circuit chips and the like under vacuum.

The fabrication and investigation/measurement of present-day electronic circuitry more often than not requires processing under vacuum, be it that the processing steps per se must be performed under vacuum or that cleanliness requirements can only be met if enough dust-carrying air or gas has been pumped from the environment so that vacuum conditions obtain. For example, the manufacture of electronic circuits involves a plurality of steps of different nature, like etching, evaporation, sputtering, etc., which for chemical or space reasons cannot be performed at one single location. In past processing apparatus the device being manufactured, or the probe under investigation had to be removed from one work station and transferred to the next, and each such transfer of necessity involved venting the first work station and evacuating the second, a process which, including the required baking, could easily require tens of hours to complete. The yield achievable with these systems is reduced in view of the fact that certain devices suffer from repeated venting and evacuating.

Known in the prior art are various transport systems and handling devices such as, for example, those disclosed in the IBM Technical Disclosure Bulletin, Vol. 18, No. 11, pp. 3669 through 3676 and 3679, 3680. These and other handling devices either operate under normal ambient conditions or even use streams of air as transport means. Also known in the art are linear transfer devices for use under vacuum conditions which permit the movement of objects along a linear path, say into and out of a processing chamber through an airlock system (see the article by Y. Budo et al, "Modular vacuum system", in IBM Technical Disclosure Bulletin, Vol. 17, No. 8, pp. 2268—2269). None of these devices in the prior art is conceived for serving a plurality of processing chambers belonging to the same vacuum-protected system in a circular arrangement about a central chamber.

It is, therefore, an object of the present invention to design a vacuum-compatible transfer device which is capable of moving a circular chip or similar object between a plurality of processing locations without requiring the venting and re-evacuating of the system or parts thereof in connection with each move of the object in question.

Accordingly, the invention contemplates the design of a vacuum transfer device for transferring objects within a protected system of evacuatable chambers, the device comprising a central chamber and a plurality of additional chambers radially arranged around said central chamber, the latter being provided with a table having a rotor on top which carries a coulisse arrangement for transferring the objects situated thereon upon alignment of said coulisse arrangement with any one of said additional chambers, through appropriate extension of said coulisse arrangement.

Details of one embodiment of the invention will hereafter be described by way of example and with the aid of the attached drawings in which

Fig. 1 shows a top plan view of an arrangenent of processing chambers;

Fig. 2 is a vertical cross section through the central chamber and an input chamber of Fig. 1 with the coulisse arrangement in home position;

Fig. 3 is a perspective view of the coulisse arrangement and its drive mechanism;

Fig. 4 shows details of the traction mechanism of the coulisse arrangement of Fig. 3;

Fig. 5 shows the coulisse arrangement in extended position reaching into another chamber;

Fig. 6 shows an embodiment of a position indicator used on the coulisse arrangement;

Fig. 7 is a schematic illustration of a guide roller system used to horizontally align the coulisse arrangement when extended.

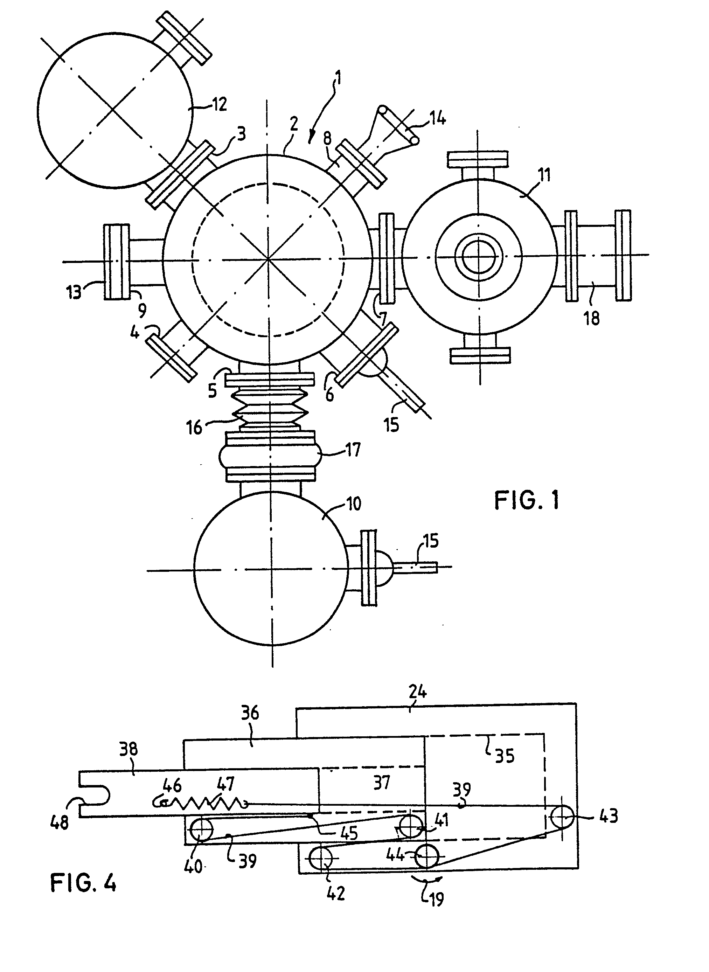

Referring to Fig. 1, a central processing chamber 1 consists of a cylindrical or spherical autoclave 2 having a plurality of flanges 3 through 9 which permit the vacuum-tight connection of processing chambers such as, e.g. chambers 10, 11 and 12. Flanges 4, 6, 8 and 9 may be used to connect additional processing chambers or may be equipped with optical inspection means, like window 13, or camera 14, receive manipulators such as manipulator 15, or may simply be closed, as flange 4 as shown in Fig. 1. The interconnection between central chamber 1 and any additional chamber 10, 11, 12 may be provided with a bellows 16 and a slide valve 17, as shown for chamber 10. Closing the connection to slide valve 17 during processing guarantees that no contaminating material can propagate through the bellows and distribute to other chambers.

Chamber 11 is designed as input/exit port for the entire system. It is provided with an airlock 18 through which the circuit chip (for example) can be introduced into the system, or removed therefrom.

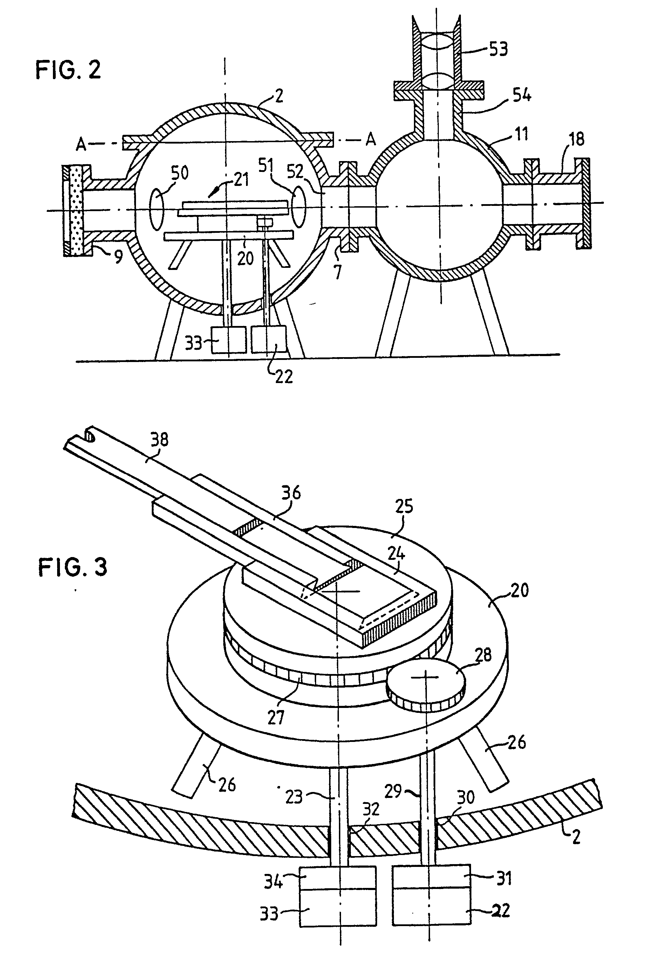

Fig. 2 shows a vertical cross section through central chambers 1 and 11. Central chamber 1 may be divided along line A—A to permit access to its interior construction. Inside chamber 1 is mounted a transfer mechanism comprising a table 20 on which is rotatably mounted a coulisse arrangement 21 which can be rotated by a motor 22 so as to be aligned with any one of the ducts leading to flanges 3 through 9.

Details of the rotary drive of the coulisse arrangement 21 are shown in Fig. 3. A base plate 24 of the coulisse arrangement 21 is attached to a rotor 25 rotatably supported on table 20 which rests on legs 26 on the interior surface of autoclave 2. Rotor 25 is provided with a toothing 27 which is in engagement with a pinion 28 sitting on a shaft 29. Leading through a vacuum-tight rotational motion feedthrough 30, shaft 29 is connected to an angular positioner 31 which is attached to motor 22. Positioner 31 permits the exact alignment of coulisse arrangement 21 with any one of the additional chambers 10 . . . 12 as may be required during processing.

Also leading through a vacuum-tight rotational motion feedthrough 32 is a shaft 23 which drives coulisse arrangement 21 from a motor 33 and an angular positioner 34. Since coulisse arrangement 21 is to be free to rotate through 360°, shaft 23 is arranged concentric with respect to the base plate 24 of coulisse arrangement 21. A simple toothed-wheel gearing (not shown) is provided to transfer the rotation of shaft 23 to the excentrically located driving drum.

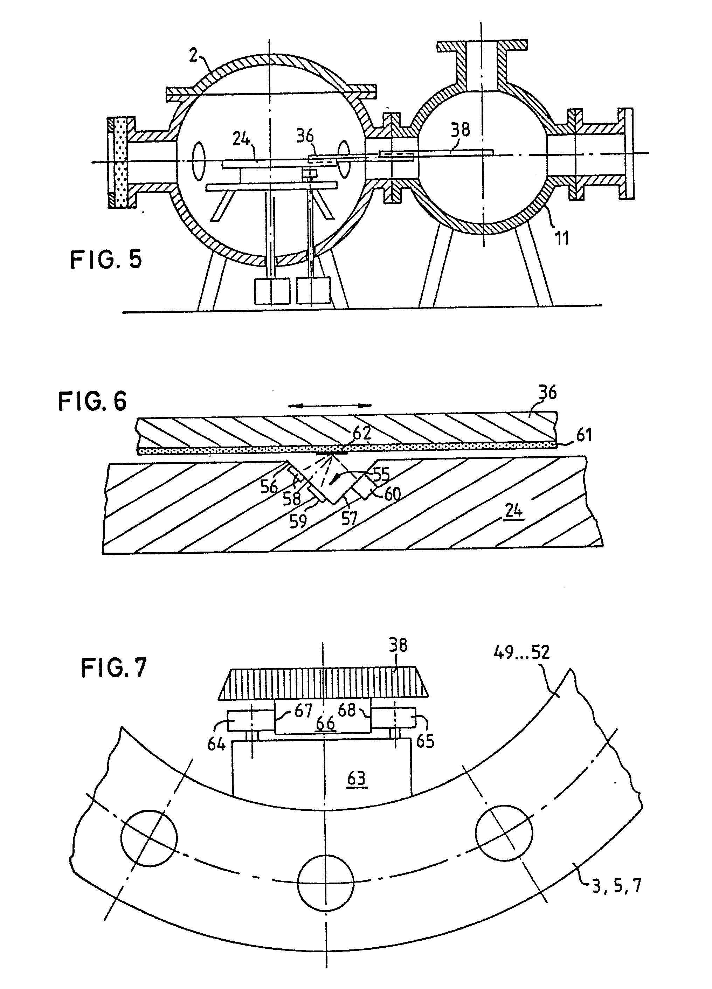

Coulisse arrangement 21 is conceived as a three-part extendable support (Fig. 4) consisting of base plate 24 receiving in its dovetailed groove 35 a first slider 36 which in turn in the dovetailed groove 37 thereof receives a second slider 38. Coulisse arrangement 21 can be extended by means of a wire traction system comprising a cable 39, pulleys 40 through 43, and cable drum 44. One end of cable 39 is secured at point 45 to said second slider 38 from where it is slung around a first pulley 40 rotatably supported on the front end of the first slider 36, and around a second pulley 41 on the rear end of slider 36. Rotatably supported on the front end of base plate 24 is a third pulley 42, and cable 39 coming from pulley 41 is slung around pulley 42, thence for a full winding around cable drum 44, still around a fourth pulley 43 from where it is returned to a point 46 on second slider 38 where it is fixed.

Cable drum 44 is connected via shaft 23 to the angular positioner 34 of motor 33. As drum 44 is rotated in the direction of arrow 19, the cable 39 between pulleys 41 and 42 as well as between pulley 40 and point 45 is shortened pulling sliders 36 and 38 to extend, sliding in grooves 35 and 37, respectively. Rotating cable drum 44 in the direction against arrow 19 causes the cable between pulley 43 and point 46 to become shortened, thus pulling the sliders 36 and 38 back into base plate 24. To avoid any slack in cable 39, a spring 47 may, for example, be inserted where cable 39 reaches point 46 on the second slider 38. By appropriate design of sliders 36, 38 and suitable placement of pulleys 40 through 43, coulisse arrangement 21 can be made to be movable backward beyond its home position, thus obviating the necessity of turning through 180° for addressing a location opposite the previously addressed location.

Referring to Fig. 2, coulisse arrangement 21 can be rotated by motor 22 to become aligned with any desired one of the openings 49 through 52 in autoclave 2, respectively leading to flanges 9, 3, 8 and 7, in this order, or to any of the other openings not shown in Fig. 2. When the alignment of coulisse arrangment 21 with the selected opening is perfect, motor 33 is actuated to extend sliders 36 and 38 through the respective opening into the annexed processing chamber, as schematically shown in Fig. 5.

The exact position of the extending slider 38 carrying the device being manufactured, or the probe under investigation, can be monitored and, if necessary, corrected by means of position sensors. The position can optionally be observed through a measuring microscope 53 attached to a flange 54 arranged on top of chamber 11 shown, by way of example, in Fig. 2. To aid in the positioning of slider 38, optical position indicators may be provided.

Fig. 6 shows parts of base plate 24 and of its slider 36. Machined into the bed of base plate 24 is a beveled recess 55 having its two walls 56 and 57 form a right angle. Embedded in wall 56 are two UHV-compatible infrared-sensitive photodiodes 58, 59 and embedded in wall 57 is an infrared light-emitting diode 60. Attached to slider 36 is a glass plate 61 which carries an evaporated gold reflector 62. Obviously, when slider 36 while sliding in base plate 24 passes gold reflector 62 over recess 55, the radiation emitted by LED 60 will be reflected onto photodiodes 58, 59. The correct position for slider 36 will be reached when both diodes 58 and 59 receive the same amount of reflected radiation. This will yield equilibrium in a bridge circuit not shown. In a way known in the art, the bridge circuit may be made part of the controls for motor 33 responsible for the extension of coulisse arrangement 21.

Several reflectors 62 may be placed on slider 36 to permit precise positioning thereof at several desired locations. Of course, the position indicator of Fig. 6 may also be used to control the mutual displacement between sliders 36 and 38.

A slight alignment problem may be encountered when coulisse arrangement 21 is extended into an adjacent processing chamber as a result of a minute temperature-induced displacement of that chamber with respect to central processing chamber 1.

To remedy this problem, a system of guide rollers may be used in the neighbourhood of the used flanges of each of the processing chambers 1, 10, 12 and/or at the work stations and at the loading point in airlock 18 of chamber 11. Fig. 7 schematically discloses the guide roller system contemplated.

Fig. 7 shows two guide rollers 64,65 arranged in one of the openings 49 through 52, with their axes being vertically supported in a console 62. A guide bar 66 having rolling surfaces 67, 68 is fixed to slider 38.

The vacuum transfer device in accordance with the present invention should be controlled by a control unit performing the following functions: Maintenance of the appropriate vacuum conditions including the baking of the entire vacuum transfer device after evacuation; actuation of the slide valves 17 to permit slider 38 to access a selected one of the additional processing chambers and to permit loading the object to be subjected to manufacturing or measuring steps through the airlock 18; rotary and linear movement of the coulisse arrangement 21 as required by the job performed.

It will be self-evident that appropriate controls should also be provided for controlling the necessary processing steps to be performed within the additional chambers 10 . . . 12.

To prevent accidents during the transfer of the object, the following checks are provided:

— The vacuum on both sides of a slide valve 17 to be opened is checked prior to opening. If the difference significant, a balancing adjustment is made.

— The coulisse arrangement 21 is locked until the slide valve leading to a selected processing chamber is opened.

— The rotor of the coulisse arrangement 21 is properly arrested as long as the sliders 36, 38 are not in their home positions.

— The slide valves 17 are locked in their open position as long as the coulisse arrangement 21 is extended. All of these control functions and checks can be governed by a computer.

It will be clear to those skilled in the art that all parts used in the transfer device in accordance with the invention must be vacuum-compatible and able to sustain baking up to about 500 K for an extended period of time. For example, the photodiodes 58, 59 used in the position indicator are made vacuum-compatible through removal of their protective plastic covers.

## Claims

1. Vacuum transfer device for transferring objects within a protected system of evacuatable chambers, characterized in that said system comprises a central chamber (1) and a plurality of additional chambers (10 . . . 12) arranged radially around said central chamber (1), and that the latter is provided with a table (20) having a rotor (25) on top which carries a coulisse arrangement (21) for transferring the objects situated thereon upon alignment of said coulisse arrangement (21) with any one of said additional chambers (10 . . . 12) through appropriate extension of the coulisse arrangement (21).

2. Transfer device in accordance with claim 1, characterized in that the coulisse arrangement (21) comprises a base plate (24) provided with a first dovetailed groove (35) for slidably receiving therein a first slider (36) which in turn is provided with a second dovetailed groove (37) therein slidably receiving a second slider (38), means being provided permitting controlled extension and retraction of said sliders (36, 38) with respect to the base plate (24).

3. Transfer device in accordance with claim 2, characterized in that said extension and retraction means is designed as a wire traction system comprising a cable (39) with both ends (45, 46) fixed to said second slider (38) and slung around a plurality of pulleys (40 . . . 43) as well as around a cable drum (44) which is driven by a motor (33) such that rotation of said cable drum (44) in one direction (19) results in an extension of said coulisse arrangement (21), whereas rotation of said cable drum (44) in the opposite direction provokes retraction of said coulisse arrangement.

4. Transfer device in accordance with claim 1, characterized in that said rotor (25) is provided with a toothing (27) which is in engagement with a pinion (28) being in driving connection with a motor (22).

5. Transfer device in accordance with claim 3 or 4, characterized in that the motor (22, 33) drives the coulisse arrangement (21) via a shaft (23, 29) passing through the wall of said central processing chamber (1) by way of a vacuum-tight rotational motion feedthrough (30, 32) and that said shaft (23, 29) is connected to said motor (22, 33) by an angular positioner (31, 34).

6. Transfer device in accordance with claim 2, characterized in that said coulisse arrangement (21) comprises at least one position indicator consisting of a bevelled recess (55) machined into said base plate (24) and/or said first slider (36) and in its beveled walls (56, 57) respectively carrying a pair of adjacent photodiodes (58, 59) and a light emitting diode (60), and a reflector (62) attached to said first slider (36) and/or said second slider (38) so that it is passed over said recess (55), a conventional bridge circuit being set to equilibrium as both photodiodes receive the same amount of radiation from said light-emitting diode (60).

7. Transfer device in accordance with claim 1, characterized in that the coulisse arrangement (21) comprises a guide bar (66) being fixed to said slider (36, 38) and having a pair of beveled rolling surfaces (67, 68) cooperating with a pair of rollers (64, 65) arranged on a rigid console (63).

## Patentansprüche

1. Vakuumfördervorrichtung zum Tranferieren von Gegenständen innerhalb eines geschützten Systems von evakuierbaren Kammern, dadurch gekennzeichnet, daß das genannte System eine zentrale Kammer (1) und eine Mehrzahl von zusätzlichen Kammern (10 . . . 12) umfasst, die um die zentrale Kammer (1) radial angeordnet sind, und daß die letztere mit einem Tisch (20) ausgerüstet ist, der auf seiner Oberseite einen Rotor (25) aufweist, welcher eine Kulissenanordnung (21) trägt, für den Transfer der darauf befindlichen Gegenstände durch geeignete Verlägerung der Kulissenanordnung, sobald die genannte Kulissenanordnung (21) mit einer der genannten zusätzlichen Kammern (10 . . . 12) ausgerichtet ist.

2. Vakuumfördervorrichtung gemäß Anspruch 1, dadurch gekennzeichnet, daß die Kulissenanordnung (21) eine Basisplatte (24) umfaßt, die eine erste Schwalbenschwanznut (35) für einen darin verschiebbaren ersten Schieber (36) aufweist, der seinerseits eine zweite Schwalbenschwanznut (37) für die Aufnahme eines zweiten verschiebbaren Schiebers (38) aufweist, wobei Mittel für die kontrollierte Verlängerung und Verkürzung der genannten Schieber (36, 38) bezüglich der Basisplatte (24) vorgesehen sind.

3. Vakuumfördervorrichtung gemäß Anspruch 2, dadurch gekennzeichnet, daß die Mittel für die Verlängerung und Verkürzung als Kabelzugsystem mit einem Kabel (39) ausgebildet sind, welches mit seinen beiden Enden (45, 46) an dem genannten zweiten Schieber (38) befestigt ist und um eine Mehrzahl von Seilscheiben (40 . . . 43) sowie eine Kabeltrommel (44) geführt ist, die von einem Motor (33) derart angetrieben ist, daß die Drehung der Kabeltrommel (44) in einer Richtung (19) die Verlängerung der Kulissenanordnung (21) bewirkt, während die Drehung der Kabeltrommel (44) in entgegengesetzter Richtung eine Verkürzung der Kulissenanordnung bewirkt.

4. Vakuumfördervorrichtung gemäß Anspruch 1, dadurch gekennzeichnet, daß der genannte Rotor (25) mit einer Verzahnung (27) versehen ist, die mit einem Ritzel (28) in Eingriff ist, das mit einem Motor (22) in Antriebsverbindung steht.

5. Vakuumfördervorrichtung gemäß Anspruch 3, dadurch gekennzeichnet, daß der Motor (22, 33) die Kulissenanordnung (21) mittels einer Welle (23, 29) antreibt, die durch eine in der Wand der zentralen Kammer (1) angeordnete vakuumdichte Rotationsdurchführung (30, 32) hindurchgeführt ist, und daß die genannte Welle (23, 29) mit dem Motor (22, 33) mittels eines Winkeleinstellers (31, 34) verbunden ist.

6. Vakuumfördervorrichtung gemäß Anspruch 2, dadurch gekennzeichnet, daß die genannte Kulissenanordnung (21) wenigstens einem Positionsmelder aufweist, der eine geneigte Eindrehung (55) in der Basisplatte (24) und/oder dem ersten Schieber (36) umfaßt, und die in ihren geneigten Wänden (56, 57) ein Paar von nebeneinanderliegenden Photodioden (58, 59) und eine lichtemittierende Diode sowie einen am genannten ersten Schieber (36) und/oder am genannten zweiten Schieber (38) befestigten Reflektor (62) trägt, der die genannte Eindrehung (55) überstreicht, wobei eine herkömmliche Brückenschaltung sich in ihrer Gleichgewichtslage befindet, wenn beide Photodioden die gleiche Lichtmenge von der lichtemittierenden Diode (60) empfangen.

7. Vakuumfördervorrichtung gemäß Anspruch 1, dadurch gekennzeichnet, daß die Kulissenanordnung (21) eine Führungsschiene (66) aufweist, die an dem genannten Schieber (36, 38) befestigt ist und ein Paar geneigter Laufflächen (67, 68) hat, die mit einem Rollenpaar (64, 65) zusammenwirken, welches auf einer feststehenden Konsole (63) angeordnet ist.

**Revendications**

1. Dispositif de transort sous vide pour transférer des objets à l'intérieur d'un système protégé de chambres pouvant être mises sous vide, caractérisé en ce que ledit système comprend une chambre centrale (1) et une pluralité de chambres additionnelles (10 . . . 12) agencées radialement autour de ladite chambre centrale (1), et en ce que cette dernière comporte une table (20) sur laquelle est monté un rotor (25) qui porte un dispositif à coulisse (21) pour transférer les objets situés sur celui-ci lors de l'alignement de ce dispositif à coulisse (21) avec l'une quelconque desdites chambres additionnelles (10 . . . 12) par extension appropriée du dispositif à coulisse (21).

2. Dispositif de transport suivant la revendication 1, caractérisé en ce que le dispositif à coulisse (21) comprend une plaque de base (24) comportant une première rainure trapézoïdale (35) pour recevoir de façon coulissante un premier coulisseau (36) qui comporte lui-même une deuxième rainure trapézoïdale (37) pour recevoir de façon coulissante un deuxième coulisseau (38), des moyens étant prévus pour permettre une extension et une rétraction contrôlées desdits coulisseaux (36, 38) par rapport à la plaque de base (24).

3. Dispositif de transport suivant la revendication 2, caractérisé en ce que lesdits moyens d'extension et de rétraction sont constitués par un système de traction à câble comprenant un câble (39) dont les deux extrémités (45, 46) sont fixées audit deuxième coulisseau (38) et qui est renvoyé autour d'une pluralité de poulies (40 . . . 43) ainsi qu'autour d'un tambour de câble (44) qui est entraîné par un moteur (33) de sorte que la rotation de ce tambour de câble (44) dans une direction (19) provoque une extension du dispositif à coulisse (21) tandis que la rotation du tambour de câble (44) dans la direction opposée provoque la rétraction du dispositif à coulisse.

4. Dispositif de transport suivant la revendication 1, caractérisé en ce que ledit rotor (25) comporte une denture (27) que est en prise avec un pignon (28) en liaison d'entraînement avec un moteur (22).

5. Dispositif de transport suivant la revendication 3 ou 4, caractérisé en ce que le moteur (22, 33) entraîne le dispositif à coulisse (21) par l'intermédiaire d'un arbre (23, 29) qui traverse la paroi de ladite chambre centrale de traitement (1) au moyen d'une traversée de mouvement rotatif (30, 32) étanche au vide, et en ce que ledit arbre (23, 29) est accouplé audit moteur (22, 33) par un positionneur angulaire (31, 34).

6. Dispositif de transport suivant la revendication 2, caractérisé en ce que le dispositif à coulisse (21) comprend au moins un indicateur de position constitué d'une gorge triangulaire (55), usinée dans la dite plaque de base (24) et/ou ledit premier coulisseau (36) et dont les parois inclinées (56, 57) portent respectivement deux photodiodes adjacentes (58, 59) et une diode émettrice de lumière (60), et d'un réflecteur (62) fixé audit premier coulisseau (36) et/ou audit deuxième coulisseau (38) de façon à passer au-dessus de la dite gorge (55), un circuit à pont usuel étant mis en équilibre lorsque les deux photodiodes reçoivent la même quantité de rayonnement de ladite diode émettrice de lumière (60).

7. Dispositif de transport suivant la revendication 1, caractérisé en ce que le dispositif à coulisse (21) comprend une barre de guidage (66) fixée audit coulisseau (36, 38) et présentant deux surfaces de roulement inclinées (67, 68) qui coopèrent avec deux galets (64, 65) montés sur une console rigide (63).

FIG. 1

FIG. 4

FIG. 2

FIG. 3

FIG. 5

2

24    36    38

11

FIG. 6

36

62

61

56    55

58    60

59    57

24

FIG. 7

38    49...52

67    68

64    66    65

63

3, 5, 7